(19) Europäisches Patentamt / European Patent Office / Office européen des brevets

(11) **EP 3 469 668 B1**

(12) **FASCICULE DE BREVET EUROPEEN**

(45) Date de publication et mention de la délivrance du brevet:
**27.05.2020 Bulletin 2020/22**

(21) Numéro de dépôt: **17735206.9**

(22) Date de dépôt: **12.06.2017**

(51) Int Cl.:
*H01S 3/10* *(2006.01)*        *H01S 3/30* *(2006.01)*
*H01S 5/065* *(2006.01)*      *H01S 3/00* *(2006.01)*

(86) Numéro de dépôt international:
**PCT/FR2017/051491**

(87) Numéro de publication internationale:
**WO 2017/216459 (21.12.2017 Gazette 2017/51)**

(54) **MODULE D'AFFINEMENT SPECTRAL, DISPOSITIF À RAIE SPECTRALE AFFINÉE ET PROCÉDÉ AFFÉRENT**

SPEKTRALES VERFEINERUNGSMODUL, VORRICHTUNG MIT VERFEINERTER SPEKTRALLINIE UND ZUGEHÖRIGES VERFAHREN

SPECTRAL REFINEMENT MODULE, DEVICE WITH REFINED SPECTRAL LINE AND ASSOCIATED METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.06.2016 FR 1655456**

(43) Date de publication de la demande:
**17.04.2019 Bulletin 2019/16**

(73) Titulaires:
• **Université de Rennes I**
  **35065 Rennes Cedex (FR)**
• **Centre National de la Recherche Scientifique**
  **75016 Paris (FR)**

(72) Inventeurs:
• **ALOUINI, Mehdi**
  **35140 Gosne (FR)**
• **DANION, Gwennaël**
  **35650 Le Rheu (FR)**
• **VALLET, Marc**
  **35235 Thorigne Fouillard (FR)**

(74) Mandataire: **Verriest, Philippe et al**
**Cabinet Germain & Maureau**
**12, rue Boileau**
**BP 6153**
**69466 Lyon Cedex 06 (FR)**

(56) Documents cités:
**WO-A2-2008/047329      US-A1- 2011 134 940**

• THÉVENAZ L ET AL: "Novel schemes for optical signal generation using laser injection locking with application to Brillouin sensing; Novel schemes for optical signal generation using laser injection locking with application to Brillouin sensing", MEASUREMENT SCIENCE AND TECHNOLOGY, IOP, BRISTOL, GB, vol. 15, no. 8, 1 août 2004 (2004-08-01), pages 1519-1524, XP020066605, ISSN: 0957-0233, DOI: 10.1088/0957-0233/15/8/015
• CASTRO M ET AL: "Self-injection locking of DFB laser diode with Brillouin amplification in optical fibre feedback", ELECTRONICS LETTERS, IEE STEVENAGE, GB, vol. 43, no. 15, 19 juillet 2007 (2007-07-19), pages 802-804, XP006029371, ISSN: 0013-5194, DOI: 10.1049/EL:20070499

**EP 3 469 668 B1**

## Description

### Domaine de l'invention

Le domaine de la présente invention concerne celui des sources lumineuses produisant un faisceau lumineux amplifié par émission stimulée de radiation. Elle concerne particulièrement, mais pas exclusivement, le domaine des modules d'affinement spectral. Plus précisément, la présente invention concerne les procédés d'affinement spectral d'une source lumineuse par introduction d'un faisceau lumineux préalablement affiné spectralement.

### Art antérieur

De nos jours, de nombreuses applications nécessitent l'utilisation de source lumineuse ayant de faibles largeurs de raie optique. Ces applications sont généralement la métrologie optique, la spectroscopie, les télécommunications, les systèmes radars, la manipulation d'atomes et les horloges atomiques. Cependant les sources lumineuses actuellement sur le marché comprennent une importante largeur de raie. Bien entendu, il existe des sources lumineuses ayant une faible largeur de raie, toutefois elles présentent l'inconvénient d'être souvent complexes, peu puissantes, peu accordables et surtout coûteuses. Par ailleurs, cette présente invention se démarque des techniques de l'état de l'art en ce qu'il ne s'agit pas d'une injection maître-esclave classique qui nécessite forcément deux source différentes : une source maître, une esclave. Voir à ce sujet les documents suivants:

- WO 2008/047329 A2;
- Thévenaz: "Novel schemes for optical signal génération using laser injection locking with application to Brillouin sensing", Measuremernt Science and Technology, vol. 15, n° 8, 1 août 2004, pages 1519-1524;
- Castro: "Self-injection locking of DFB laser diode with Brillouin amplification in optical fibre feedback", Electronics Letters, vol. 43, n° 15, 19 juillet 2007, pages 802-804;
- US 2011/134940 A1 (HARTOG) 9 juin 2011.

### Exposé de l'invention

La présente invention a pour but de résoudre tout ou partie des inconvénients mentionnés ci-dessus sous la forme d'un module d'affinement spectral pour au moins une première source lumineuse, le module d'affinement spectral comprenant :

- au moins un premier coupleur ; ledit au moins un premier coupleur est configuré pour dériver au moins un premier faisceau lumineux de pompage à partir d'un premier faisceau lumineux incident provenant de ladite au moins une première source lumineuse et introduit dans le module d'affinement spectral ;

- un résonateur Brillouin ; le résonateur Brillouin est configuré pour générer, à partir d'au moins une portion dudit premier faisceau lumineux de pompage, au moins un premier faisceau lumineux résonant ; et

- un modulateur ; le modulateur est configuré pour générer, à partir du premier faisceau lumineux résonant, au moins un premier faisceau lumineux modulé;

le module d'affinement spectral est configuré pour introduire totalement ou partiellement le premier faisceau lumineux modulé dans ledit au moins un premier coupleur, ledit au moins un premier coupleur est configuré pour introduire totalement ou partiellement le premier faisceau lumineux modulé dans ladite au moins une première source lumineuse de manière à affiner la raie spectrale de ladite au moins une première source lumineuse.

Les avantages de cette invention sont multiples. Le module d'affinement de raie spectral est applicable à toute source lumineuse et ce de n'importe quelle longueur d'onde. Préférentiellement, le module d'affinement selon l'invention peut être utilisé pour des lasers « distributed feedback » plus connus sous le nom de laser DFB, souvent utilisés pour des applications dans le domaine des télécommunications qui possèdent une qualité spectrale médiocre mais qui sont extrêmement peu couteux, très compactes et consommant peu. Les sources lumineuses semi-conducteurs ont par ailleurs l'avantage de couvrir un domaine de longueur d'onde allant du bleu à l'infrarouge, comme par exemple de 400 nm à 12 $\mu$m. La compatibilité de l'invention à ce type de source lumineuse et notamment à ce type de laser est une avancée notable car elle apporte une solution très simple et peu couteuse à un nombre important d'applications telle que les horloges à césium ou rubidium, qui nécessitent des lasers spectralement très fins et oscillants à des fréquences extrêmement précises dans le très proche infrarouge. L'utilisation d'un laser semi-conducteur compact, de type DFB, et de technologies fibrées rend l'invention compatible avec des environnements hostiles y compris l'environnement aéroporté et spatial.

En résumé, l'invention offre à la fois une faible largeur de raie, une grande accordabilité, un extrêmement large domaine de longueur d'onde d'utilisation, une bonne compacité, une excellente robustesse, une compatibilité avec des plateformes en environnement sévère, un faible poids, une consommation modérée en énergie et un faible coût.

Le module d'affinement spectral peut en outre présenter une ou plusieurs des caractéristiques suivantes, prises seules ou en combinaison.

Selon un mode de réalisation non limitatif, ledit au moins un premier coupleur est configuré pour introduire totalement ou partiellement le premier faisceau lumineux modulé dans ladite au moins une première source lumineuse de manière à lui conférer la finesse de raie de la lumière modulée.

Selon un mode de réalisation non limitatif, le modulateur est configuré pour générer, à partir du premier faisceau lumineux résonant, au moins un premier faisceau lumineux modulé dont au moins une des composantes spectrales est distante de maximun 50 GHz de la composante spectrale de ladite au moins une première source lumineuse.

Avantageusement, grâce à cette disposition, le module d'affinement spectral génère un premier faisceau lumineux de signal ayant une faible largeur de raie spectrale pouvant être utilisé à différentes fins.

Selon un mode de réalisation non limitatif, ledit au moins un premier coupleur est configuré pour dériver un premier faisceau lumineux de signal à partir du premier faisceau lumineux incident provenant de ladite au moins une première source lumineuse et introduit dans le module d'affinement spectral.

Avantageusement, grâce à cette disposition, le module d'affinement spectral génère un premier faisceau lumineux de signal ayant une faible largeur de raie spectrale pouvant être utilisé à différentes fins.

Selon un mode de réalisation non limitatif :

- ledit au moins un premier coupleur est configuré pour dériver au moins un deuxième faisceau lumineux de pompage à partir d'un deuxième faisceau lumineux incident provenant d'une deuxième source lumineuse et introduit dans le module d'affinement spectral ;

- le résonateur Brillouin est configuré pour générer, à partir d'au moins une portion du deuxième faisceau lumineux de pompage, un deuxième faisceau lumineux résonant ; et

- le modulateur est configuré pour générer, à partir du deuxième faisceau lumineux résonant, au moins un deuxième faisceau lumineux modulé,

le module d'affinement spectral est configuré pour introduire totalement ou partiellement le deuxième faisceau lumineux modulé dans ledit au moins un premier coupleur, ledit au moins un premier coupleur est configuré pour introduire totalement ou partiellement le deuxième faisceau lumineux modulé dans la deuxième source lumineuse de manière à affiner la raie spectrale de la deuxième source lumineuse.

Avantageusement, grâce à cette disposition, le module d'affinement spectral génère un deuxième faisceau lumineux affiné à partir de la deuxième source lumineuse, éventuellement à l'aide de la première source lumineuse, ayant des caractéristiques spectrales différentes de la première source lumineuse et présentant une faible largeur de raie spectrale pouvant être utilisée à différentes fins.

Selon un mode de réalisation non limitatif, le modulateur est configuré pour générer, à partir du deuxième faisceau lumineux résonant, au moins un deuxième faisceau lumineux modulé dont au moins une des composantes spectrales est distante de maximum 50 GHz de la composante spectrale de la deuxième source lumineuse.

Avantageusement, grâce à cette disposition, le modulateur génère, à partir du deuxième faisceau lumineux résonant, au moins un deuxième faisceau lumineux modulé dont au moins une des composantes spectrales est proche de la composante spectrale de la deuxième source lumineuse.

Selon un mode de réalisation non limitatif, ledit au moins un premier coupleur est configuré pour dériver un deuxième faisceau lumineux de signal à partir du deuxième faisceau lumineux incident provenant de la deuxième source lumineuse et introduit dans le module d'affinement spectral.

Avantageusement, grâce à cette disposition, le module d'affinement spectral génère un deuxième faisceau lumineux de signal à partir de la deuxième source lumineuse ayant des caractéristiques spectrales différentes de la première source lumineuse et présentant une faible largeur de raie spectrale pouvant être utilisé à différentes fins.

Selon un mode de réalisation non limitatif, le modulateur est configuré pour générer, à partir du premier faisceau lumineux résonant, un deuxième faisceau lumineux modulé apte à affiner la raie spectrale d'une deuxième source lumineuse.

Selon un mode de réalisation non limitatif, le deuxième faisceau lumineux modulé comprend au moins une composante spectrale apte à affiner la raie spectrale d'une deuxième source lumineuse.

Selon un mode de réalisation non limitatif, le deuxième faisceau lumineux modulé comprend une composante spectrale configurée pour affiner la raie spectrale d'une deuxième source lumineuse.

Avantageusement, grâce à cette disposition, le module d'affinement spectral génère un deuxième faisceau lumineux affiné, à partir de la première source lumineuse, ayant des caractéristiques spectrales différentes de la première source lumineuse et présentant une faible largeur de raie spectrale pouvant être utilisé à différentes fins.

Selon un mode de réalisation non limitatif, le module d'affinement spectral comprend un deuxième coupleur ; le deuxième coupleur est configuré pour introduire totalement ou partiellement le deuxième faisceau lumineux modulé provenant du modulateur dans la deuxième source lumineuse de sorte à affiner la raie spectrale de la deuxième source lumineuse.

Avantageusement, grâce à cette disposition, le module d'affinement spectral génère un deuxième faisceau lumineux affiné présentant une faible largeur de raie spectrale pouvant être utilisé à différentes fins.

Selon un mode de réalisation non limitatif, le deuxième coupleur est configuré pour dériver au moins un deuxième faisceau lumineux de signal à partir du deuxième faisceau lumineux incident provenant de la deuxième source lumineuse et introduit dans le module d'affinement spectral.

Avantageusement, grâce à cette disposition, le module d'affinement spectral génère un deuxième faisceau lumineux de signal présentant une faible largeur de raie.

Selon un mode de réalisation non limitatif, le module d'affinement spectral comprend un troisième coupleur configuré pour générer, à partir d'au moins un faisceau lumineux de signal parmi le premier faisceau lumineux de signal provenant dudit au moins un premier coupleur et le deuxième faisceau lumineux de signal provenant du deuxième coupleur, un troisième faisceau lumineux de signal.

Avantageusement, grâce à cette disposition, le module d'affinement spectral génère un troisième faisceau lumineux de signal comprenant au moins une faible largeur de raie spectrale parmi le premier faisceau lumineux de signal et le deuxième faisceau lumineux de signal.

Selon un mode de réalisation non limitatif, le troisième faisceau lumineux de signal, comprend totalement ou partiellement au moins un faisceau lumineux de signal parmi le premier faisceau lumineux de signal de ladite au moins une première source lumineuse et le deuxième faisceau lumineux de signal de la deuxième source lumineuse, le troisième faisceau lumineux de signal est généré par au moins un coupleur parmi ledit au moins un premier coupleur et le troisième coupleur.

Selon un mode de réalisation non limitatif, le module d'affinement spectral est configuré pour introduire le premier faisceau lumineux modulé dans le deuxième coupleur de sorte à être introduit totalement ou partiellement dans la deuxième source lumineuse et de manière à affiner la raie spectrale de la deuxième source lumineuse.

Avantageusement, grâce à cette disposition, seule une portion de la puissance de la première source lumineuse est utilisée pour affiner la raie spectrale de la deuxième source lumineuse sans qu'une partie de sa puissance soit utilisée.

Selon un mode de réalisation non limitatif, le module d'affinement spectral est configuré pour introduire le deuxième faisceau lumineux modulé dans ledit au moins un premier coupleur de sorte à être introduit totalement ou partiellement dans la première source lumineuse et de manière à affiner la raie spectrale de la première source lumineuse.

Avantageusement, grâce à cette disposition, seule une portion de la puissance de la deuxième source lumineuse est utilisée pour affiner la raie spectrale de la première source lumineuse sans qu'une partie de sa puissance soit utilisée.

Selon un mode de réalisation non limitatif, le premier coupleur est configuré pour dériver au moins un premier faisceau lumineux de signal à partir du premier faisceau lumineux incident provenant de ladite au moins une première source lumineuse et introduit dans le module d'affinement spectral.

La présente invention concerne un dispositif à raie spectrale affinée, dans lequel au moins une source lumineuse parmi ladite au moins une première source lumineuse et la deuxième source lumineuse est caractérisée par l'émission d'au moins un faisceau lumineux incident parmi ledit au moins un premier faisceau lumineux incident et le deuxième faisceau lumineux incident possédant totalement ou partiellement les propriétés spectrales d'au moins un faisceau lumineux modulé parmi ledit au moins un premier faisceau lumineux modulé et le deuxième faisceau lumineux modulé, de sorte à permettre au dispositif à raie spectrale affinée de s'auto-entretenir et de produire au moins un faisceau lumineux de signal parmi le premier faisceau lumineux de signal et le deuxième faisceau lumineux de signal possédant totalement ou partiellement les propriétés spectrales desdits au moins un faisceau lumineux parmi ledit au moins un faisceau lumineux incident et ledit au moins un faisceau lumineux modulé.

La présente invention concerne un dispositif à raie spectrale affinée comprenant au moins un module d'affinement spectral selon l'invention et au moins une première source lumineuse associée audit au moins un module d'affinement spectral.

Les avantages de cette invention sont multiples. Le dispositif à raie spectrale affinée peut utiliser toute source lumineuse et ce de n'importe quelle longueur d'onde. Préférentiellement, le dispositif à raie spectrale affinée selon l'invention peut utiliser des lasers DFB qui possèdent une qualité spectrale médiocre mais qui sont extrêmement peu couteux, très compactes et consommant peu. Ainsi le dispositif à raie spectrale affinée permet de couvrir un domaine de longueur d'onde allant du bleu à l'infrarouge, comme par exemple de 400 nm à 12 $\mu$m. De part sa compatibilité, le dispositif à raie spectrale affinée apporte une solution très simple et peu couteuse à un nombre important d'applications telle que les horloges à césium ou rubidium, qui nécessitent des lasers spectralement très fins et oscillants à des fréquences extrêmement précises dans le très proche infrarouge. L'utilisation d'un laser semi-conducteur compact, de type DFB, et de technologies fibrées rend l'invention compatible avec des environnements hostiles y compris l'environnement aéroporté et spatial.

Selon un mode de réalisation non limitatif, le dispositif à raie spectrale affinée est configuré pour émettre le premier faisceau lumineux de signal ou le troisième faisceau lumineux de signal.

La présente invention concerne un procédé d'affinement spectral pour au moins une première source lumineuse émettant un premier faisceau lumineux incident, le procédé d'affinement spectral comprenant les étapes :

- une dérivation du premier faisceau lumineux incident provenant de ladite au moins une première source lumineuse de sorte à générer un premier faisceau lumineux dit premier faisceau lumineux de pompage ;

- une mise en résonnance d'au moins une portion dudit premier faisceau lumineux dit premier faisceau lumineux de pompage de sorte à générer un premier faisceau lumineux résonant ;

- une modulation d'au moins une portion du faisceau lumineux dit premier faisceau lumineux résonant de sorte à générer au moins un premier faisceau lumineux modulé; et

- une introduction totalement ou partiellement dudit au moins un premier faisceau lumineux modulé dans ladite au moins une première source lumineuse de sorte à affiner la raie spectrale de ladite au moins une première source lumineuse.

Le procédé d'affinement spectral peut en outre présenter une ou plusieurs des caractéristiques suivantes, prises seules ou en combinaison.

Selon un mode de réalisation non limitatif, lors de l'étape de modulation, au moins une portion du premier faisceau lumineux résonant est modulée de sorte à générer un deuxième faisceau lumineux modulé.

Selon un mode de réalisation non limitatif, lors de l'étape de modulation, au moins une portion du premier faisceau lumineux résonant est modulée de sorte à générer au moins un premier faisceau lumineux modulé dont au moins une des composantes spectrales est distante de maximum 50 GHz de la composante spectrale de ladite au moins une première source lumineuse.

Avantageusement, grâce à cette disposition, l'étape de modulation génère, à partir du deuxième faisceau lumineux résonant, au moins un deuxième faisceau lumineux modulé dont au moins une des composantes spectrales est proche de la composante spectrale de la deuxième source lumineuse.

Selon un mode de réalisation non limitatif, lors de l'étape d'introduction, le deuxième faisceau lumineux modulé est introduit totalement ou partiellement dans une deuxième source lumineuse de sorte à affiner la raie spectrale de la deuxième source lumineuse.

Selon un mode de réalisation non limitatif, le procédé d'affinement spectral utilise le module d'affinement spectral selon l'invention ou le dispositif à raie spectrale affinée selon l'invention.

D'autres caractéristiques et avantages de l'invention apparaîtront mieux à la lecture de la description qui suit d'un mode de réalisation de l'invention donné à titre d'exemple non limitatif.

## Liste des figures

L'invention sera mieux comprise à l'aide de la description détaillée qui est exposée ci-dessous en regard du dessin, dans lesquels :

- la figure 1 représente un exemple de raie spectrale ordinaire et une raie spectral affinée ;

- la figure 2 montre un exemple de dispositif à raie spectrale affinée **200** et de module d'affinement spectral **100** dans lequel le procédé selon l'invention est mis en œuvre ;

- la figure 3 illustre un exemple de dispositif à raie spectrale affinée **200** et de module d'affinement spectral **100** comprenant deux sources lumineuses Selon un mode de réalisation non limitatif dans lequel le procédé selon l'invention est mis en œuvre ;

- la figure 4 expose un exemple dispositif à raie spectrale affinée **200** et de module d'affinement spectral 100 comprenant deux sources lumineuses Selon un mode de réalisation non limitatif dans lequel le procédé selon l'invention est mis en œuvre ;

- la figure 5 présente un exemple de raie spectrale d'une source lumineuse selon un premier mode de réalisation ;

- la figure 6 représente un exemple de faisceau lumineux résonant selon un premier mode de réalisation ;

- la figure 7 montre un exemple de faisceau lumineux modulé selon un premier mode de réalisation ;

- la figure 8 illustre un exemple de deux raies spectrales de deux sources lumineuses selon un deuxième mode de réalisation ;

- la figure 9 expose un exemple de deux faisceau lumineux résonants selon un deuxième mode de réalisation ;

- la figure 10 présente un exemple de deux faisceau lumineux modulés selon un deuxième mode de réalisation ;

- la figure 11 représente un exemple de deux raies spectrales de deux sources lumineuses selon un deuxième mode de réalisation ;

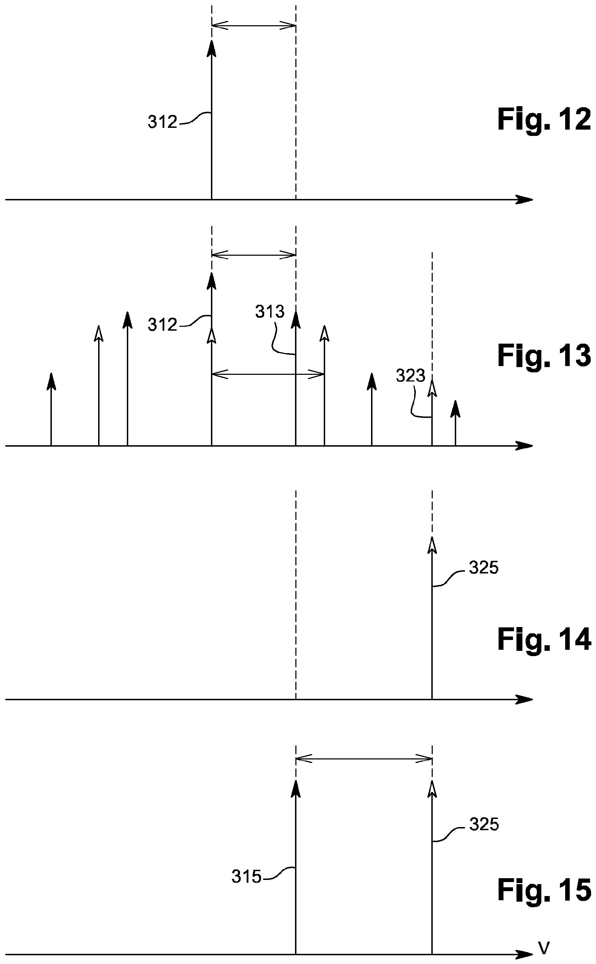

- la figure 12 montre un exemple de un faisceau lumineux résonants **312** selon un troisième mode de réalisation ;

- la figure 13 illustre un exemple d'un faisceau lumineux modulé à deux fréquences de modulations selon un troisième mode de réalisation ;

- la figure 14 expose un exemple de raie spectrale d'une source lumineuse selon un troisième mode de réalisation ;

- la figure 15 présente la combinaison de la première source lumineuse et de la deuxième source lumineuse selon l'invention ;

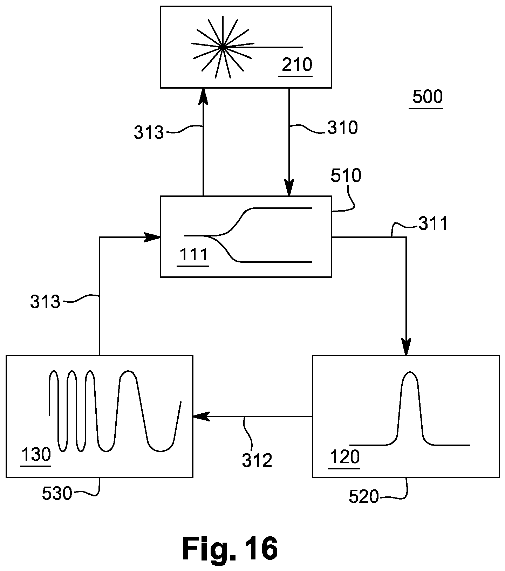

- la figure 16 illustre le principe général du procédé d'affinement spectral **500** pour au moins une première source lumineuse **210** selon le premier mode de réalisation ; et

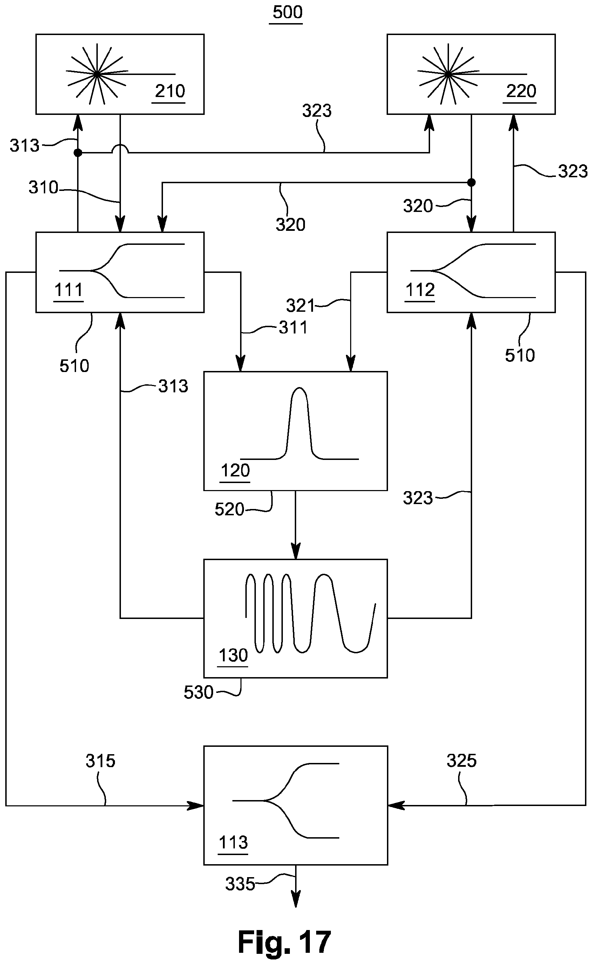

- la figure 17 représente les étapes du procédé d'affinement spectral **500** pour au moins deux source lumineuse selon les deuxième et troisième modes de réalisations.

Dans la description détaillée qui va suivre des figures définies ci-dessus, les mêmes éléments ou les éléments remplissant des fonctions identiques pourront conserver les mêmes références de manière à simplifier la compréhension de l'invention.

### Description générale de l'invention

### Principe général

L'invention porte sur l'utilisation conjointe d'un résonateur **120** en particulier un résonateur Brillouin **120** et d'un modulateur **130** afin d'affiner la raie spectrale d'au moins une source lumineuse. Une partie de la puissance de ladite au moins une première source lumineuse est prélevée par un ledit au moins un premier coupleur afin d'être utilisée comme onde signal utile. L'autre partie de la puissance est utilisée pour pomper le résonateur Brillouin **120** qui permettra d'affiner la raie laser.

Le résonateur **120,** et notamment le résonateur Brillouin **120,** est configuré pour être pompé à l'aide de ladite au moins une source lumineuse **210**. Le terme « pomper » est bien connu de l'homme du métier. L'onde dite pompe **311** (a la fréquence $v_p$) va interagir avec les ondes acoustiques présentes dans le milieu considéré. Cette interaction correspond à la diffusion inélastique de l'onde dite pompe sur le réseau d'indice induit par les ondes acoustiques, se traduisant par la génération par effet Brillouin d'une onde lumineuse, appelée onde Stokes **312** (à la fréquence $v_s$). Le battement de celle-ci avec l'onde de pompe **311** va créer une modulation d'intensité et un réseau d'indice qui se propagent à la vitesse $C_a$, qui tendra à amplifier l'onde acoustique résultante. L'onde acoustique ainsi créée diffuse davantage l'onde pompe, ce qui renforce l'onde Stokes. Ainsi de suite, les deux processus se renforcent l'un l'autre et entrainent une amplification de l'onde Stokes.

Le résonateur **120** est également configuré pour être résonant pour l'onde Stokes **312** générée par effet Brillouin, et donc l'onde Stokes **312** peut être qualifiée d'onde Brillouin **312,** de longueur d'onde $v_b$, et est idéalement non-résonante pour la longueur d'onde de ladite au moins une première source lumineuse, ou plus exactement pour la longueur d'onde de pompage $v_p$.

Le phénomène de résonance optique consiste à faire circuler sur plusieurs tours l'onde lumineuse dans un résonateur optique. Ce mécanisme confère à l'onde issue du résonateur une finesse de raie accrue. Lorsque le résonateur optique présente du gain (obtenu ici par la pompe au travers de l'effet Brillouin), l'onde générée (Ondes Stokes ici) possède une largeur de raie inversement proportionnelle à la longueur du résonateur et au nombre de tours effectués, et à la puissance lumineuse de cette onde.

La longueur d'onde de ladite au moins une première source lumineuse ne joue pas de rôle pour l'effet Brillouin contrairement à un laser à gaz par exemple. C'est d'ailleurs grâce à cela que la présente invention fonctionne à n'importe quelle longueur d'onde.

Ainsi, une partie du faisceau de cette source lumineuse est utilisée pour pomper le résonateur Brillouin **120**. L'onde Stokes **312,** c'est-à-dire le faisceau lumineux résonant, issue du résonateur Brillouin **120** est naturellement décalée d'une jusqu'à un maximum d'une cinquantaine de Gigahertz par rapport à la longueur d'onde d'émission de ladite au moins une première source lumineuse, autrement dit du faisceau lumineux de pompage et par extension du faisceau lumineux incident. Le résonateur **120** est généralement non-résonant pour ladite au moins une première source lumineuse de sorte à permettre un fonctionnement optimal à n'importe quelle fréquence de ladite au moins une première source lumineuse. L'onde Brillouin **312,** ou onde de Stokes **312,** produite est résonante.

Un ledit au moins un premier coupleur **111** permet d'extraire une partie du faisceau lumineux incident **310** et de diriger l'onde de pompe **311** vers le résonateur **120**. L'onde Brillouin **312** est dirigée vers un modulateur **130**. Ces deux ondes, c'est-à-dire le faisceau lumineux de pompage dit onde de pompe et le faisceau lumineux résonant dit onde Brillouin **312,** sont décalées en fréquence l'une de l'autre. Le résonateur **120** est préférentiellement fibré de sorte à avoir une intégration simplifiée et très facile et dont le coût est faible et l'encombrement très faible puisque la fibre peut être enroulée autour d'une bobine. Bien évidemment, d'autres architectures de résonateur peuvent être envisagées, car l'effet Brillouin peut être obtenu dans d'autres matériaux, gaz ou liquide.

Une fois pompé, le résonateur Brillouin **120** se comporte comme une source lumineuse qui oscille à la fréquence de l'onde Stokes **312.**

Le modulateur **130** peut être, selon les modes de réalisation, un modulateur d'intensité type Mach-Zehnder, un modulateur de phase, un modulateur à bande latérale unique, un acousto-optique, ou un modulateur de lumière suivi de tout effet non linéaire optique. Le modulateur **130** module le faisceau lumineux résonant dit onde Brillouin **312** à la fréquence de décalage afin de faire apparaître au moins une raie optique de même fréquence ou proche de 20GHz que le laser source **210**. Cette raie est ensuite introduite dans le laser source **210** au moyen de ledit au moins premier coupleur **111**. L'introduction de l'onde Stokes modulé **313** permet d'affiner spectralement ladite au moins une première source lumineuse **210**.

Le fonctionnement d'un modulateur est connu de l'homme du métier et ne nécessite pas d'être représenté. En effet, ce dispositif **130** produit une variation en fonction du temps à la fréquence dite de modulation de l'une des grandeurs caractérisant l'oscillation lumineuse périodique nommée porteuse. Cette variation conduit à la génération d'au moins une raie optique décalée de la fréquence de modulation. En d'autre termes, un modulateur optique **130** est un composant optoélectronique généralement commandé par un signal électrique, qui fournit un signal optique modulé, généralement en intensité, lorsqu'un signal optique continu dans le temps est appliqué à l'entrée.

Le résonateur Brillouin **120** est composé d'une boucle fibrée de plusieurs dizaines de mètre. Cette boucle est non résonante à la fréquence du laser source **210**. Cette caractéristique est vrai quelle que soit la fréquence du laser source **210**. L'onde de pompe **311** n'est pas résonnante car le résonateur Brillouin **120** ne l'est pas pour le sens de propagation de l'onde de pompe **311**. Le résonateur Brillouin **120** est, par contre, résonant dans l'autre sens, i.e., celui de propagation de l'onde Stokes **312**.

L'onde Brillouin **312** de fréquence $v_b$, générée dans le sens inverse, est quant à elle résonante. L'onde Brillouin **312** de fréquence $v_b$ est extraite à l'aide d'un coupleur intégré (non représenté) au résonateur Brillouin **120**, est ensuite transmise audit au moins un premier coupleur **111**.

L'onde Brillouin **312** de fréquence $v_b$ est extraite par un ledit au moins un premier coupleur **111**. L'écart de fréquence entre le laser source **210** de fréquence $v_p$, et le laser Brillouin de fréquence $v_b$, dépend des caractéristiques de la boucle Brillouin, des propriétés de la fibre utilisée dans le résonateur Brillouin **120**, et de la longueur d'onde d'émission du laser source. La fréquence de l'onde Brillouin **312** est définie comme :

$$v_b = v_p \left(1 - 2\frac{nc_a}{c}\right)$$

Avec $v_p$, la fréquence de ladite au moins une première source lumineuse **210**, **n** l'indice optique de la fibre, c la célérité de lumière et $c_a$ la vitesse des ondes acoustique dans le milieu dans lequel la fréquence de ladite au moins une première source lumineuse **210** se propage. L'onde de fréquence $v_b$ issue du laser Brillouin, plus exactement issue du résonateur Brillouin **120** est ensuite envoyée vers un modulateur **130** de lumière. Le modulateur **130** donne naissance à des raies de part et d'autre de la fréquence de l'onde incidente de fréquence $v_b$ dont l'écart de fréquence est donné par $mf_{ol}$, $f_{ol}$ étant la fréquence de modulation **530** et $m$ un entier. La fréquence $f_{ol}$ est ajustée afin de correspondre à la fréquence de décalage Brillouin, soit $f_{ol} = \Delta v = (|v_p - v_b|)$. Ainsi, nous générons une fréquence $v'_p$ correspondant à la fréquence optique du laser source, qui selon la modulation appliquée peut correspondre à une fréquence différente à celle de $v_p$ :

$$v'_p = v_b + f_{ol} \equiv v_p$$

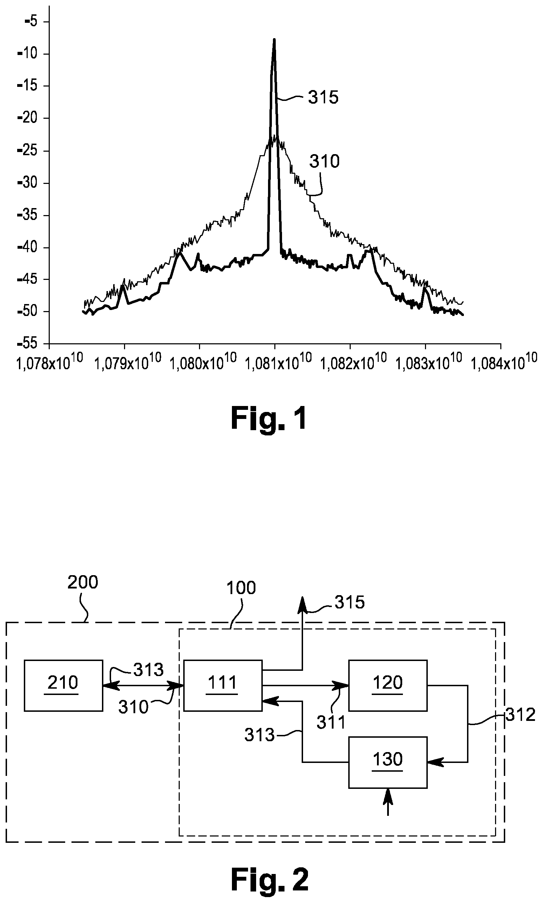

Cette onde générée de fréquence $v'_p = v_b + f_{ol}$ est ensuite envoyée vers le laser source **210**. Cette onde générée de fréquence $v'_p$ possède la même fréquence que le laser source **210**, cependant, l'onde générée de fréquence $v'_p$ a été affinée spectralement grâce au résonateur Brillouin **120**. Son introduction dans ladite au moins une première source lumineuse **210** vient donc affiner sa raie spectrale elle-même. Ce mécanisme s'auto entretient naturellement et permet de stabiliser ladite au moins une première source lumineuse **210**. En effet, une fois spectralement affiné, le laser de pompe **210** possède les propriétés spectrales optimales pour pomper à nouveau le résonateur Brillouin **120** et être d'avantage affiné. Typiquement, la largeur de raie initiale mesurée à -3 dB de la valeur pic ou à mi-hauteur soit à 50 % de la valeur pic et qui peut être de quelques Megahertz, voir figure 1 courbe **310**, devient de l'ordre de quelques dizaines à quelques Hertz voir inférieure au Hertz, voir par exemple figure 1 courbe **315**, par ce procédé d'introduction optique. Il est à noter que l'invention ne requiert aucun asservissement électronique. La technique n'est donc pas limitée par la bande passante des boucles à verrouillage de phase.

La technique n'est donc pas limitée par la bande passante d'une contreréaction électronique, ce qui la rend compatible avec l'affinement spectral de raies larges comme celles des lasers semi-conducteurs du type (diode laser, Fabry-Perot, Laser à cascade quantique, VCSEL, à cavité externe étendue. etc.) ou tout autre laser présentant une raie trop large pour être asservie par des moyens électroniques comme par exemple les lasers solide (Nd:YAG, Er:YAG, Er:Yb, etc...), les lasers à boites ou fils quantiques, les laser Raman, les laser à fibre, les laser à gaz, les laser à colorant, les lasers chimique, les laser à électrons libres, les leds et les oleds.

Il est possible d'introduire dans le laser une harmonique d'ordre supérieur créée par le modulateur **130** afin de réduire la fréquence de modulation **530** si nécessaire. Il est possible d'utiliser un amplificateur optique (non représenté) si la puissance optique délivrée par le laser source n'est pas suffisante. Finalement, le signal utile **315** peut être l'onde issue du laser pompe **210,** comme décrit ici, ou bien l'onde Stokes **312** issue du résonateur Brillouin **120.**

Par ailleurs, lorsque le faisceau lumineux modulé **313** est introduite dans de ladite au moins une première source lumineuse **210,** des sauts de modes du résonateur Brillouin **120** sont évités, ce qui permet d'obtenir un résonateur Brillouin **120** stable dans le temps.

En outre, comme signalé précédemment, il est possible de disposer un amplificateur de sorte à ne pas être limité par la puissance du résonateur Brillouin.

Les avantages de cette invention sont multiples. La technique est applicable à n'importe quel type de source lumineuse, notamment aux lasers, et à n'importe quelle longueur d'onde. On peut en effet utiliser des lasers semi-conducteurs qui possèdent une qualité spectrale médiocre mais qui sont extrêmement peu couteux pour produire des largeurs de raie très fines. Les lasers semi-conducteurs ont par ailleurs l'avantage de couvrir un domaine de longueur d'onde allant du bleu à l'infrarouge. La compatibilité de l'invention à ce type de lasers est une avancée notable car l'invention apporte une solution très simple et peu couteuse à un nombre important d'applications. Les horloges à césium ou rubidium, par exemple, nécessitent des lasers spectralement très fins et oscillants à des fréquences extrêmement précises dans le très proche infrarouge. L'invention répond à ce type de besoin. L'utilisation d'un laser semi-conducteur compact et de technologies fibrées rend l'invention compatible avec des environnements hostiles y compris l'environnement aérospatial et/ou maritime.

En résumé, l'invention offre à la fois une faible largeur de raie, une grande accordabilité, un extrêmement large domaine de longueur d'onde d'utilisation, une bonne compacité, une excellente robustesse, une compatibilité avec des plateformes en environnement sévère, un faible poids, une consommation modérée et un faible coût.

**Description générale d'un premier mode de réalisation**

Sur la figure 2 est représenté un module d'affinement spectral **100.** Le module d'affinement spectral **100,** pour au moins une première source lumineuse **210,** comprenant au moins un premier ledit au moins un premier coupleur **111,** un résonateur Brillouin **120** et un modulateur **130.**

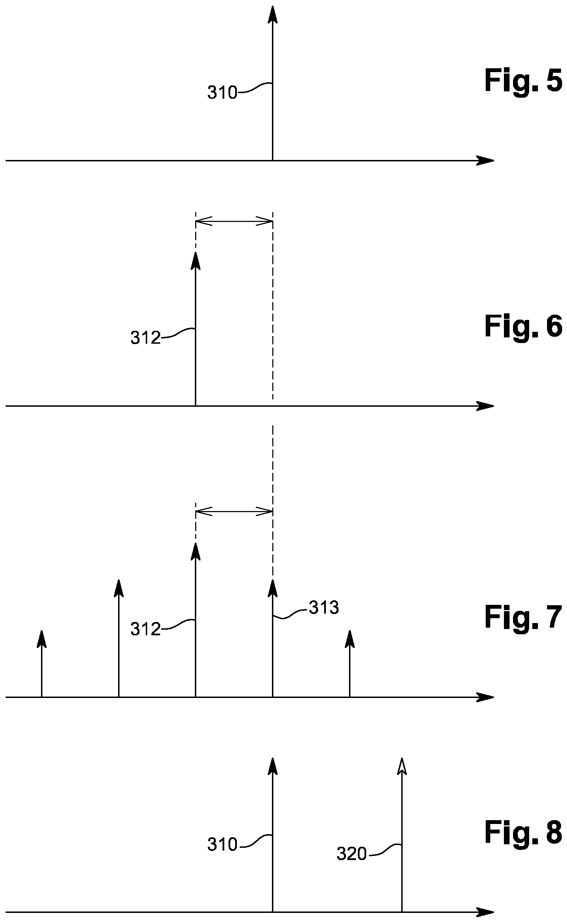

La source lumineuse émet un premier faisceau lumineux comme représenté sur la figure 5. Pour des raisons de simplification, seul le pic de longueur d'onde utile **315** sera représenté dans les graphiques des figures de la présente demande et/ou du présent brevet. Le premier ledit au moins un premier coupleur **111** est configuré pour dériver au moins un premier faisceau lumineux de pompage **311** à partir d'un premier faisceau lumineux incident **310** provenant de ladite au moins une première source lumineuse **210** et introduit dans le module d'affinement spectral **100.** Le premier faisceau lumineux de pompage **311** est dirigé vers le résonateur Brillouin **120.**

Ce résonateur Brillouin **120** est configuré pour générer, à partir d'au moins une portion dudit premier faisceau lumineux de pompage **311,** au moins un premier faisceau lumineux résonant **312.** Le faisceau lumineux résonant **312** est décalé en fréquence de quelques gigahertz à dizaines de gigahertz, comme l'expose la figure 6. Ce premier faisceau lumineux résonant **312** est envoyé vers le modulateur **130.**

Le modulateur **130** est configuré pour générer, à partir du premier faisceau lumineux résonant **312,** au moins un premier faisceau lumineux modulé **313.** En pratique, le faisceau lumineux modulé **313** peut se présenter avec une harmonique ou avec plusieurs harmoniques. Ainsi, le premier faisceau lumineux modulé **313** est introduit par l'intermédiaire dudit au moins un premier coupleur **111** dans ladite au moins une première source lumineuse **210** de manière à affiner la raie spectrale de ladite au moins une première source lumineuse **210.**

Le premier ledit au moins un premier coupleur **111** est configuré pour dériver un premier faisceau lumineux de signal **315** à partir du premier faisceau lumineux incident **310** provenant de ladite au moins une première source lumineuse **210** et introduit dans le module d'affinement spectral **100.**

**Description générale d'un deuxième mode de réalisation**

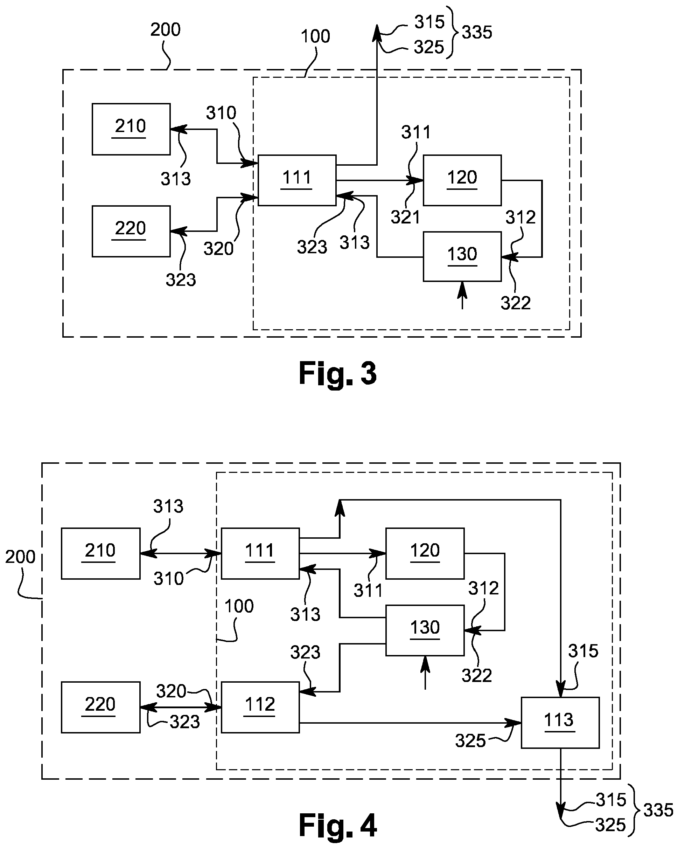

Le deuxième mode de réalisation exposé sur la figure 3 est à peu près similaire au premier mode de réalisation. En effet, en plus de la première source lumineuse **210,** le deuxième mode de réalisation comprend une deuxième source lumineuse **220.** La deuxième source lumineuse **220** est transmise au premier ledit au moins un premier coupleur **111** par l'intermédiaire d'un milieu tel que du verre, un gaz, un cristal par exemple. L'intérêt de cette disposition est d'affiner les deux sources lumineuses, c'est-à-dire la première source lumineuse **210** et la deuxième source lumineuse **220** ou d'affiner seulement la deuxième source lumineuse **220** à l'aide de la première source lumineuse **210.**

Sur la figure 8 est exposée la raie spectrale de la première source lumineuse **310** et la raie spectrale de la deuxième source lumineuse **320.** Ces deux raies spectrales sont injectées dans le module d'affinement spectral **100.** Comme dans le premier mode de réalisation, le module d'affinement spectral **100** comprend un premier ledit au moins un premier coupleur **111,** un résonateur Brillouin **120** et un modulateur **130.**

Comme mentionné précédemment, la première source lumineuse **210** ainsi que la deuxième source lumineuse **220** sont incidente au premier ledit au moins un premier coupleur **111.** Les deux sources lumineuses peuvent pomper le résonateur **120.** Comme dans le premier mode de réalisation, ledit au moins un premier coupleur **111** dérive le premier faisceau lumineux de pompage **311** à partir du premier faisceau lumineux incident **310** provenant de la première source lumineuse **210** et le deuxième faisceau lumineux de pompage **321** à partir du deuxième faisceau lumineux incident **320** provenant de la deuxième source lumineuse **220.**

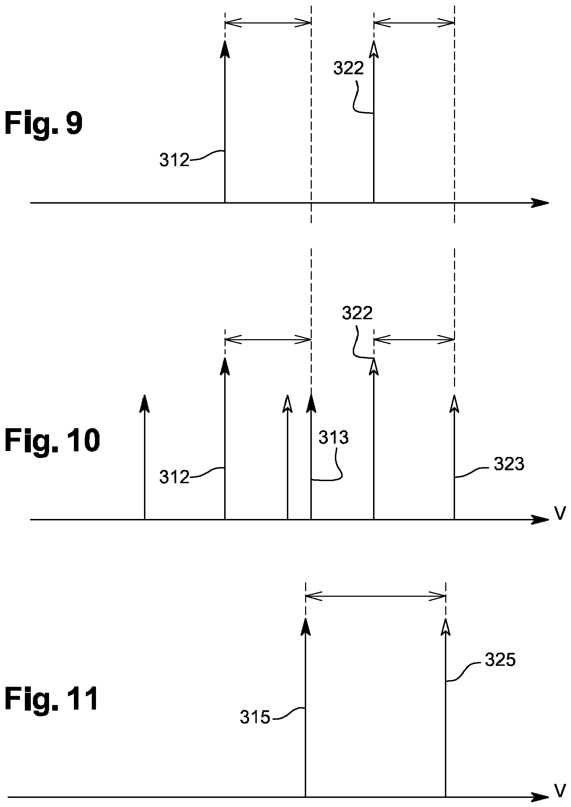

Le résonateur **120** génère à partir du première faisceau lumineux de pompage **311** un premier faisceau lumineux résonant **312** et à partir du deuxième faisceau lumineux de pompage **321** un deuxième faisceau lumineux résonant **322.** Comme dans le premier mode de réalisation, le premier faisceau lumineux résonant **312** et le deuxième faisceau lumineux résonant **322** sont décalés en fréquence par rapport au premier faisceau lumineux incident **310** et également par rapport au deuxième faisceau lumineux incident **320.** Le premier faisceau lumineux résonant **312** et le deuxième faisceau lumineux résonant **322** sont décalés en fréquence de quelques gigahertz à dizaines de gigahertz, comme l'expose la figure 9. Le premier faisceau lumineux résonant **312** et le deuxième faisceau lumineux résonant **322** sont envoyés vers le modulateur **130.**

Le premier faisceau lumineux résonant **312** et le deuxième faisceau lumineux résonant **322** donnent naissance à un premier faisceau lumineux modulé **313** et à un deuxième faisceau lumineux modulé **323** respectivement.

Le modulateur **130** génère, à partir du premier faisceau lumineux résonant **312** et du deuxième faisceau lumineux résonant **322,** au moins un premier faisceau lumineux modulé **313** et un deuxième faisceau lumineux modulé **323.** En pratique, le premier faisceau lumineux modulé **313** et le deuxième faisceau lumineux modulé **323** peuvent se présenter avec différentes harmoniques.

Le premier faisceau lumineux et le deuxième faisceau lumineux sont réintroduits dans le ledit au moins un premier coupleur totalement ou partiellement. Ledit au moins un premier coupleur **111** introduit totalement ou partiellement le deuxième faisceau lumineux modulé **323** dans la deuxième source lumineuse **220** de manière à affiner la raie spectrale de la deuxième source lumineuse **220.**

Dans ce mode de réalisation, il est également possible de prévoir que ledit au moins un premier coupleur **111** introduit totalement ou partiellement le premier faisceau lumineux modulé **313** dans la deuxième source lumineuse **220** de manière à affiner la raie spectrale de la deuxième source lumineuse **220** si les caractéristiques de la raie spectrale de la première source lumineuse **210** le permettent.

### Description générale d'un troisième mode de réalisation

Dans ce troisième mode de réalisation montré sur la figure 4, seule la première source lumineuse **210** sera utilisée pour affiner la deuxième source lumineuse **220.** En effet, dans cette configuration le module d'affinement spectral **100** comprend un premier ledit au moins un premier coupleur **111,** un deuxième ledit au moins un premier coupleur **112,** un troisième ledit au moins un premier coupleur **113,** un résonateur Brillouin **120** et un modulateur **130.**

La première source lumineuse **210** émet un premier faisceau lumineux. Le premier ledit au moins un premier coupleur **111** est configuré pour dériver au moins un premier faisceau lumineux de pompage **311** à partir d'un premier faisceau lumineux incident **310** provenant de ladite au moins une première source lumineuse **210** et introduit dans le module d'affinement spectral **100.** Le premier faisceau lumineux de pompage **311** est dirigé vers le résonateur Brillouin **120.**

Ce résonateur Brillouin **120** est configuré pour générer, à partir d'au moins une portion dudit premier faisceau lumineux de pompage **311,** au moins un premier faisceau lumineux résonant **312.** Le faisceau lumineux résonant est décalé en fréquence de quelques gigahertz à quelques dizaines de gigahertz, comme l'expose la figure 6. Ce premier faisceau lumineux résonant **312** est envoyé vers le modulateur **130.**

Le modulateur **130** est configuré pour générer, à partir du premier faisceau lumineux résonant **312,** un premier faisceau lumineux modulé **313** et un deuxième faisceau lumineux modulé **323.**

En effet, à partir du premier faisceau lumineux résonant, le premier faisceau lumineux résonnant **312** présente des harmoniques différentes qui correspondent au premier faisceau lumineux incident **310** et au deuxième faisceau lumineux incident **320** respectivement.

Ce mode de réalisation permet de d'affiner la première source lumineuse **210** à l'aide du premier faisceau lumineux modulé **313** mais également, la deuxième source lumineuse **220.**

En effet, le deuxième faisceau lumineux de la source et dirigé vers le deuxième ledit au moins un premier coupleur **112** afin d'affiner la raie spectrale de la deuxième source lumineuse **220.**

La raie spectrale du faisceau lumineux affinée est introduite dans le deuxième ledit au moins un premier coupleur **112.** Ce deuxième ledit au moins un premier coupleur **112** peut dériver un deuxième faisceau lumineux de signal **325** à partir du deuxième faisceau lumineux incident **320** provenant de la deuxième source lumineuse **220.**

Le premier faisceau lumineux affiné **315** et le deuxième faisceau lumineux affiné **325** sont introduits dans le troisième coupleur **113** afin de générer un troisième faisceau lumineux comprenant les caractéristiques spectrale du premier faisceau de signal **315** et le deuxième faisceau lumineux de signal **325.** Le battement des deux faisceaux, c'est-à-dire du premier faisceau lumineux affiné **315** et le deuxième faisceau lumineux affiné **325,** permet d'avoir un troisième faisceau lumineux affiné à plus basse fréquence, c'est-à-dire dans le domaine du Téra Hertz et/ou Giga Hertz.

## Présentation des étapes du procédé

Le module d'affinement de raie spectral mais également le dispositif à raie spectrale affiné **200** décrit précédemment peuvent fonctionner selon un procédé d'affinement spectral **500**. Ce procédé d'affinement spectral **500** peut être utilisé pour au moins une première source lumineuse **210** émettant un faisceau lumineux. Le procédé d'affinement spectral **500** comprend une dérivation **510** d'un premier faisceau lumineux incident **310**. Le premier faisceau incident **310** provenant d'au moins une première source lumineuse **210** de sorte à générer un premier faisceau lumineux **320** dit premier faisceau lumineux de pompage **311** .

Ce premier faisceau lumineux de pompage **311** est introduit dans un résonateur **120** de sorte qu'une mise en résonance **520** d'au moins une portion dudit premier faisceau dit premier faisceau lumineux de pompage **311** se produit dans le résonateur **120**. Cette mise en résonance génère un premier faisceau lumineux résonant **312**.

Ce premier faisceau lumineux résonant **312** est dirigé vers un modulateur **130**. C'est dans le modulateur **130** qu'une modulation **530** est réalisée. Effectivement, une portion dudit faisceau lumineux dit premier faisceau lumineux résonant est modulé de sorte à générer au moins un premier faisceau lumineux modulé **313** .

Ce faisceau lumineux modulé **313**, comprenant au moins une harmonique, permet un affinement de la raie spectral de la première source lumineuse **210** lorsque par l'intermédiaire d'une introduction totale ou partielle dudit premier faisceau lumineux modulé **313** dans ladite au moins une première source lumineuse **210** à lieu au moyen du premier ledit au moins un premier coupleur **111**.

Très rapidement, c'est-à-dire au bout de deux ou trois itérations, la première source lumineuse **210** est stabilisée et affinée. Dès lors, il est possible de dériver à l'aide du premier ledit au moins un premier coupleur **111** un premier faisceau lumineux de signal **315** dont la raie spectrale est affinée.

La faisabilité et la reproductibilité de l'affinement spectrale selon l'invention ont été démontrées en laboratoire de la demanderesse.

Dans cette démonstration, un laser DFB commercial de type Alcatel 1905 LMI continu, dont le pic de longueur d'onde est à 1550 nm, sera utilisé comme source lumineuse en association avec le module d'affinement spectral **100** selon l'invention. Bien évidement, cette association forme un dispositif à raie spectrale affinée **200** selon l'invention.

Cette source lumineuse émet une onde à la fréquence $v_p$ = **1550 nm.** Le premier faisceau lumineux est incident au ledit au moins un premier coupleur **111**. Une portion de ce premier faisceau lumineux incident **310** est dérivée pour générer au moins un premier faisceau lumineux de pompage **311**. Ce faisceau lumineux est introduit dans un résonateur Brillouin **120**.

Le résonateur Brillouin **120**, utilisé dans la démonstration, comprend une fibre optique formant une boucle de plus d'une centaine de mètre de longueur et ayant la caractéristique d'être non résonante pour le laser-source, dit de pompe **311**

Le faisceau lumineux de pompage **311**, généré à partir d'une portion du faisceau lumineux incident **310**, effectue un tour dans le résonateur **120**. En revanche, le faisceau lumineux résonant **312**, généré à partir d'une portion du faisceau lumineux de pompage **311**, est résonant car le faisceau lumineux résonant **312** se propage en sens inverse du faisceau lumineux de pompage **311** dans ce mode de réalisation. En effet, d'ailleurs c'est grâce à cette caractéristique que le faisceau lumineux résonant **312** est extrait de résonateur Brillouin **120**.

Selon un mode de réalisation non représenté, le faisceau lumineux résonant **312** peut être copropageant avec le faisceau lumineux de pompage **311**. Un coupleur intégré au résonateur Brillouin **120** (non représenté) permet de prélever une puissance optique comprise entre 1% et 50% selon les besoins. Il importe de préciser que la présente invention fonctionne et ce peut importe le taux de prélèvement de la puissance optique effectué par le coupleur intégré au résonateur Brillouin **120** (non représenté).

Typiquement, pour un faisceau lumineux de pompage **311** de 20 dBm, la puissance du faisceau lumineux résonant **312** extrait est de l'ordre de 7 dBm à 12 dBm. Le faisceau lumineux résonant **312** émet une fréquence $v_b$ décalée en fréquence de $\Delta v = |v_p - v_b| \cong 11$ *GHz,* par rapport au faisceau lumineux de pompage **312**. Le faisceau lumineux résonant **312** ainsi généré possède une excellente finesse spectrale de quelques dizaines de Hertz.

Le faisceau lumineux résonant **312** est ensuite envoyé vers un modulateur **130**, en l'espèce un modulateur **130** d'intensité. Les modulateurs **130** classiquement sont modulés par un synthétiseur à la fréquence $f_{OL} \cong \Delta v$. Les harmoniques de premier ordre aux fréquences $v_b \pm f_{OL}$ sont ainsi générés.

Ce faisceau lumineux modulé est ensuite introduit optiquement dans ladite au moins une première source lumineuse. Affinée spectralement et décalée en fréquence, ce faisceau lumineux modulé permet à la fois de stabiliser la fréquence et d'affiner la raie de ladite au moins une première source lumineuse, en l'occurrence d'un laser source.

Le battement $\Delta v$, observé à l'aide d'une photodiode, correspond à l'écart de fréquence entre le faisceau lumineux de pompage et le faisceau lumineux résonant. Le spectre expérimental de ce battement $\Delta v = |v_p - v_b| \cong 11$ *GHz* est présenté en figure 1.

Sur ce graphique présent à la figure 1, le premier faisceau lumineux incident **310** et le premier faisceau lumineux affiné y sont représentés. La largeur de raie du premier faisceau lumineux incident **310** est de l'ordre de 2 MHz, tandis que la largeur de raie du premier faisceau lumineux affiné a considérablement été réduite lorsque le premier faisceau lumineux modulé **313** est introduit dans ladite au moins une première source lumineuse **210**.

Lorsque le procédé d'affinement spectral **500** selon l'invention est mise en œuvre dans le deuxième et le troisième mode de réalisation, le procédé d'affinement spectral **500** présente l'avantage d'affiner les raies spectrales de la première source lumineuse **210** et de la deuxième source lumineuse **220** simultanément.

Bien évidement, en utilisant le procédé d'affinement spectral **500** selon un mode de réalisation non limitatif, le deuxième faisceau lumineux modulé **323** est introduit totalement ou partiellement dans une deuxième source lumineuse **220** de sorte à affiner la raie spectrale de la deuxième source lumineuse **220**.

## Revendications

1. Module d'affinement spectral (100) pour au moins une première source lumineuse (210), le module d'affinement spectral (100) comprenant :

   - au moins un premier coupleur (111) ; ledit au moins un premier coupleur (111) est configuré pour dériver au moins un premier faisceau lumineux de pompage (311) à partir d'un premier faisceau lumineux incident (310) provenant de ladite au moins une première source lumineuse (210) et introduit dans le module d'affinement spectral (100) ;
   - un résonateur Brillouin (120) ; le résonateur Brillouin (120) est configuré pour générer, à partir d'au moins une portion dudit premier faisceau lumineux de pompage (311), au moins un premier faisceau lumineux résonant (312) ; et
   - un modulateur (130); le modulateur (130) est configuré pour générer, à partir du premier faisceau lumineux résonant, au moins un premier faisceau lumineux modulé (313) ;

   le module d'affinement spectral (100) est configuré pour introduire totalement ou partiellement le premier faisceau lumineux modulé (313) dans ledit au moins un premier coupleur (111), ledit au moins un premier coupleur (111) est configuré pour introduire totalement ou partiellement le premier faisceau lumineux modulé (313) dans ladite au moins une première source lumineuse (210) de manière à affiner la raie spectrale de ladite au moins une première source lumineuse (210).

2. Module d'affinement spectral (100) selon la revendication 1, dans lequel ledit au moins un premier coupleur (111) est configuré pour dériver un premier faisceau lumineux de signal (315) à partir du premier faisceau lumineux incident (310) provenant de ladite au moins une première source lumineuse (210) et introduit dans le module d'affinement spectral (100).

3. Module d'affinement spectral (100) selon l'une quelconque des revendications 1 ou 2, dans lequel :

   - ledit au moins un premier coupleur (111) est configuré pour dériver au moins un deuxième faisceau lumineux de pompage (321) à partir d'un deuxième faisceau lumineux incident (320) provenant d'une deuxième source lumineuse (220) et introduit dans le module d'affinement spectral (100) ;
   - le résonateur Brillouin (120) est configuré pour générer, à partir d'au moins une portion du deuxième faisceau lumineux de pompage, un deuxième faisceau lumineux résonant (322) ; et
   - le modulateur (130) est configuré pour générer, à partir du deuxième faisceau lumineux résonant (322), au moins un deuxième faisceau lumineux modulé (323),

   le module d'affinement spectral (100) est configuré pour introduire totalement ou partiellement le deuxième faisceau lumineux modulé (323) dans ledit au moins un premier coupleur (111), ledit au moins un premier coupleur (111) est configuré pour introduire totalement ou partiellement le deuxième faisceau lumineux modulé (323) dans la deuxième source lumineuse (220) de manière à affiner la raie spectrale de la deuxième source lumineuse (220).

4. Module d'affinement spectral (100) selon la revendication 3, dans lequel ledit au moins un premier coupleur (111) est configuré pour dériver un deuxième faisceau lumineux de signal (325) à partir du deuxième faisceau lumineux incident (320) provenant de la deuxième source lumineuse (220) et introduit dans le module d'affinement spectral (100).

5. Module d'affinement spectral (100) selon la revendication 1 ou 2, dans lequel le modulateur (130) est configuré pour générer, à partir du premier faisceau lumineux résonant (312), un deuxième faisceau lumineux modulé (323) apte à affiner la raie spectrale d'une deuxième source lumineuse (220).

6. Module d'affinement spectral (100) selon la revendication 5, lequel comprenant un deuxième coupleur (112) ; le deuxième coupleur (112) est configuré pour introduire totalement ou partiellement le deuxième faisceau lumineux modulé (323) provenant du modulateur (130) dans la deuxième source lumineuse (220) de sorte à affiner la raie spectrale de la deuxième source lumineuse (220).

7. Module d'affinement spectral (100) selon la revendication 6, dans lequel le deuxième coupleur (112) est configuré pour dériver au moins un deuxième faisceau lumineux de signal (325) à partir du deuxième faisceau lumineux incident (320) provenant de la deuxième source lumineuse (220) et introduit dans le module d'affinement spectral (100).

8. Module d'affinement spectral (100) selon l'une quelconque des revendications 2 à 7, comprenant un troisième coupleur (113) configuré pour générer, à partir d'au moins un faisceau lumineux de signal parmi le premier faisceau lumineux de signal (315) provenant dudit au moins un premier coupleur (111) et le deuxième faisceau lumineux de signal (325) provenant du deuxième coupleur (112), un troisième faisceau lumineux de signal (335).

9. Module d'affinement spectral (100) selon la revendication 8, dans lequel le troisième faisceau lumineux de signal (335), comprenant totalement ou partiellement au moins un faisceau lumineux de signal parmi le premier faisceau lumineux de signal (315) de ladite au moins une première source lumineuse (210) et le deuxième faisceau lumineux de signal (325) de la deuxième source lumineuse (220), le troisième faisceau lumineux de signal (335) est généré par au moins un coupleur parmi ledit au moins un premier coupleur (111) et le troisième coupleur (113).

10. Dispositif à raie spectrale affinée (200) comprenant au moins un module d'affinement spectral (100) selon l'une quelconque des revendications 1 à 9 et au moins une première source lumineuse (210) associée audit au moins un module d'affinement spectral (100).

11. Dispositif à raie spectrale affinée (200) selon la revendication 10, lequel est configuré pour émettre le premier faisceau lumineux de signal (315) ou le troisième faisceau lumineux de signal (335).

12. Procédé d'affinement spectral (500) pour au moins une première source lumineuse (210) émettant un premier faisceau lumineux incident (310), le procédé d'affinement spectral (500) comprenant :

- une dérivation (510) du premier faisceau lumineux incident (310) provenant de ladite au moins une première source lumineuse (210) de sorte à générer un faisceau lumineux dit premier faisceau lumineux de pompage (311) ;
- une mise en résonnance (520) d'au moins une portion dudit faisceau lumineux dit premier faisceau lumineux de pompage (311) de sorte à générer un premier faisceau lumineux résonant ;
- une modulation (530) d'au moins une portion du premier faisceau lumineux résonant de sorte à générer au moins un premier faisceau lumineux modulé (313) ; et
- une introduction totale ou partielle dudit au moins un premier faisceau lumineux modulé (313) dans ladite au moins une première source lumineuse (210).

13. Procédé d'affinement spectral (500) selon la revendication 12, dans lequel lors de l'étape de modulation (530), au moins une portion du premier faisceau lumineux résonant (312) est modulée de sorte à générer un deuxième faisceau lumineux modulé (323).

14. Procédé d'affinement spectral (500) selon la revendication 13, dans lequel lors de l'étape d'introduction, le deuxième faisceau lumineux modulé (323) est introduit totalement ou partiellement dans une deuxième source lumineuse (220) de sorte à affiner la raie spectrale de la deuxième source lumineuse (220).

15. Procédé d'affinement spectral (500) selon l'une quelconque des revendications 12 à 14 utilisant le module d'affinement spectral (100) selon l'une quelconque des revendications 1 à 9 ou le dispositif à raie spectrale affinée (200) selon l'une quelconque des revendications 10 et 11.

**Patentansprüche**

1. Modul zur spektralen Verfeinerung (100) für mindestens eine erste Lichtquelle (210), wobei das Modul zur spektralen Verfeinerung (100) umfasst:

- mindestens einen ersten Koppler (111); wobei der mindestens eine erste Koppler (111) so konfiguriert ist, dass er mindestens einen ersten Pumplichtstrahl (311) aus einem ersten einfallenden Lichtstrahl (310) ableitet, der von der mindestens einen ersten Lichtquelle (210) stammt und in das Modul zur spektralen Verfeinerung (100) eingespeist wird;
- einen Brillouin-Resonator (120); wobei der Brillouin-Resonator (120) so konfiguriert ist, dass er aus mindestens einem Teil des ersten Pumplichtstrahls (311) mindestens einen ersten Resonanzlichtstrahl (312) erzeugt; und
- einen Modulator (130); wobei der Modulator (130) so konfiguriert ist, dass er aus dem ersten Resonanzlichtstrahl mindestens einen ersten modulierten Lichtstrahl (313) erzeugt;

wobei das Modul zur spektralen Verfeinerung (100) so konfiguriert ist, dass es den ersten modulierten Lichtstrahl (313) vollständig oder teilweise in den mindestens einen ersten Koppler (111) einspeist, wobei der mindestens eine erste Koppler (111) so konfiguriert ist, dass er den ersten modulierten Lichtstrahl (313) vollständig oder teilweise in die mindestens eine erste Lichtquelle (210) einspeist, um die Spektrallinie der mindestens einen ersten Lichtquelle (210) zu verfeinern.

2. Modul zur spektralen Verfeinerung (100) nach Anspruch 1, wobei der mindestens eine erste Koppler (111) so konfiguriert ist, dass er einen ersten Signallichtstrahl (315) aus dem ersten einfallenden Lichtstrahl (310) ableitet, der von der mindestens einen ersten Lichtquelle (210) stammt und in das Modul zur spektralen Verfeinerung (100) eingespeist wird.

3. Modul zur spektralen Verfeinerung (100) nach einem der Ansprüche 1 oder 2, wobei:

     - der mindestens eine erste Koppler (111) so konfiguriert ist, dass er mindestens einen zweiten Pumplichtstrahl (321) aus einem zweiten einfallenden Lichtstrahl (320) ableitet, der von einer zweiten Lichtquelle (220) stammt und in das Modul zur spektralen Verfeinerung (100) eingespeist wird;
     - der Brillouin-Resonator (120) so konfiguriert ist, dass er aus mindestens einem Teil des zweiten Pumplichtstrahls einen zweiten Resonanzlichtstrahl (322) erzeugt; und
     - der Modulator (130) so konfiguriert ist, dass er aus dem zweiten Resonanzlichtstrahl (322) mindestens einen zweiten modulierten Lichtstrahl (323) erzeugt,

wobei das Modul zur spektralen Verfeinerung (100) so konfiguriert ist, dass es den zweiten modulierten Lichtstrahl (323) vollständig oder teilweise in den mindestens einen ersten Koppler (111) einspeist, wobei der mindestens eine erste Koppler (111) so konfiguriert ist, dass er den zweiten modulierten Lichtstrahl (323) vollständig oder teilweise in die zweite Lichtquelle (220) einspeist, um die Spektrallinie der zweiten Lichtquelle (220) zu verfeinern.

4. Modul zur spektralen Verfeinerung (100) nach Anspruch 3, wobei der mindestens eine erste Koppler (111) so konfiguriert ist, dass er einen zweiten Signallichtstrahl (325) aus dem zweiten einfallenden Lichtstrahl (320) ableitet, der von der zweiten Lichtquelle (220) stammt und in das Modul zur spektralen Verfeinerung (100) eingespeist wird.

5. Modul zur spektralen Verfeinerung (100) nach Anspruch 1 oder 2, wobei der Modulator (130) so konfiguriert ist, dass er aus dem ersten Resonanzlichtstrahl (312) einen zweiten modulierten Lichtstrahl (323) erzeugt, der in der Lage ist, die Spektrallinie einer zweiten Lichtquelle (220) zu verfeinern.

6. Modul zur spektralen Verfeinerung (100) nach Anspruch 5, das einen zweiten Koppler (112) umfasst; wobei der zweite Koppler (112) so konfiguriert ist, dass er den zweiten modulierten Lichtstrahl (323), der vom Modulator (130) stammt, vollständig oder teilweise in die zweite Lichtquelle (220) einspeist, um die Spektrallinie der zweiten Lichtquelle (220) zu verfeinern.

7. Modul zur spektralen Verfeinerung (100) nach Anspruch 6, wobei der zweite Koppler (112) so konfiguriert ist, dass er mindestens einen zweiten Signallichtstrahl (325) aus dem zweiten einfallenden Lichtstrahl (320) ableitet, der von der zweiten Lichtquelle (220) stammt und in das Modul zur spektralen Verfeinerung (100) eingespeist wird.

8. Modul zur spektralen Verfeinerung (100) nach einem der Ansprüche 2 bis 7, das einen dritten Koppler (113) umfasst, der so konfiguriert ist, dass er aus mindestens einem Signallichtstrahl aus dem ersten Signallichtstrahl (315), der von dem mindestens einen ersten Koppler (111) stammt, und dem zweiten Signallichtstrahl (325), der von dem zweiten Koppler (112) stammt, einen dritten Signallichtstrahl (335) erzeugt.

9. Modul zur spektralen Verfeinerung (100) nach Anspruch 8, wobei der dritte Signallichtstrahl (335), der vollständig oder teilweise mindestens einen Signallichtstrahl aus dem ersten Signallichtstrahl (315) der mindestens einen ersten Lichtquelle (210) und dem zweiten Signallichtstrahl (325) der zweiten Lichtquelle (220) umfasst, der dritte Signallichtstrahl (335) von mindestens einem Koppler aus dem mindestens einen ersten Koppler (111) und dem dritten Koppler (113) erzeugt wird.

10. Vorrichtung mit verfeinerter Spektrallinie (200), die mindestens ein Modul zur spektralen Verfeinerung (100) nach einem der Ansprüche 1 bis 9 und mindestens eine erste Lichtquelle (210) umfasst, die mit dem mindestens einen Modul zur spektralen Verfeinerung (100) verknüpft ist.

11. Vorrichtung mit verfeinerter Spektrallinie (200) nach Anspruch 10, die so konfiguriert ist, dass sie den ersten Signallichtstrahl (315) oder den dritten Signallichtstrahl (335) emittiert.

12. Verfahren zur spektralen Verfeinerung (500) für mindestens eine erste Lichtquelle (210), die einen ersten einfallenden Lichtstrahl (310) emittiert, wobei das Verfahren zur spektralen Verfeinerung (500) umfasst:

     - ein Ableiten (510) des ersten einfallenden Lichtstrahls (310), der von der mindestens einen ersten Lichtquelle (210) stammt, um einen als ersten Pumplichtstrahl (311) bezeichneten Lichtstrahl zu erzeugen;

- ein Versetzen (520) mindestens eines Teils des als ersten Pumplichtstrahls (311) bezeichneten Lichtstrahls in Resonanz, um einen ersten Resonanzlichtstrahl zu erzeugen;

- ein Modulieren (530) mindestens eines Teils des ersten Resonanzlichtstrahls, um mindestens einen ersten modulierten Lichtstrahl (313) zu erzeugen; und

- ein vollständiges oder teilweises Einspeisen des mindestens einen ersten modulierten Lichtstrahls (313) in die mindestens eine erste Lichtquelle (210).

13. Verfahren zur spektralen Verfeinerung (500) nach Anspruch 12, wobei beim Schritt des Modulierens (530) mindestens ein Teil des ersten Resonanzlichtstrahls (312) moduliert wird, um einen zweiten modulierten Lichtstrahl (323) zu erzeugen.

14. Verfahren zur spektralen Verfeinerung (500) nach Anspruch 13, wobei beim Schritt des Einspeisens der zweite modulierte Lichtstrahl (323) vollständig oder teilweise in eine zweite Lichtquelle (220) eingespeist wird, um die Spektrallinie der zweiten Lichtquelle (220) zu verfeinern.

15. Verfahren zur spektralen Verfeinerung (500) nach einem der Ansprüche 12 bis 14 unter Verwendung des Moduls zur spektralen Verfeinerung (100) nach einem der Ansprüche 1 bis 9 oder der Vorrichtung mit verfeinerter Spektrallinie (200) nach einem der Ansprüche 10 und 11.

**Claims**

1. A spectral refinement module (100) for at least one first light source (210), the spectral refinement module (100) comprising:

- at least one first coupler (111); said at least one first coupler (111) is configured to derive at least one first pumping light beam (311) from a first incident light beam (310) originating from said at least one first light source (210) and introduced into the spectral refinement module (100);

- a Brillouin resonator (120); the Brillouin resonator (120) is configured to generate, from at least one portion of said first pumping light beam (311), at least one first resonant light beam (312); and

- a modulator (130); the modulator (130) is configured to generate, from the first resonant light beam, at least one first modulated light beam (313);

the spectral refinement module (100) is configured to totally or partially introduce the first modulated light beam (313) into said at least one first coupler (111), said at least one first coupler (111) is configured to totally or partially introduce the first modulated light beam (313) into said at least one first light source (210) so as to refine the spectral line of said at least one first light source (210).

2. The spectral refinement module (100) according to claim 1, wherein said at least one first coupler (111) is configured to derive a first signal light beam (315) from the first incident light beam (310) originating from said at least one first light source (210) and introduced into the spectral refinement module (100).

3. The spectral refinement module (100) according to any one of claims 1 or 2, wherein:

- said at least one first coupler (111) is configured to derive at least one second pumping light beam (321) from a second incident light beam (320) originating from a second light source (220) and introduced into the spectral refinement module (100);

- the Brillouin resonator (120) is configured to generate, from at least one portion of the second pumping light beam, a second resonant light beam (322); and

- the modulator (130) is configured to generate, from the second resonant light beam (322), at least one second modulated light beam (323),

the spectral refinement module (100) is configured to totally or partially introduce the second modulated light beam (323) into said at least one first coupler (111), said at least one first coupler (111) is configured to totally or partially introduce the second modulated light beam (323) into the second light source (220) so as to refine the spectral line of the second light source (220).

4. The spectral refinement module (100) according to claim 3, wherein said at least one first coupler (111) is configured to derive a second signal light beam (325) from the second incident light beam (320) originating from the second light source (220) and introduced into the spectral refinement module (100).

5. The spectral refinement module (100) according to claim 1 or 2, wherein the modulator (130) is configured to generate, from the first resonant light beam (312), a second modulated light beam (323) capable of refining the spectral line of a second light source (220).

6. The spectral refinement module (100) according to claim 5, which comprises a second coupler (112); the second coupler (112) is configured to totally or partially introduce the second modulated light beam (323) originating from the modulator (130) into the second light source (220) so as to refine the spectral line of the second light source (220).

7. The spectral refinement module (100) according to claim 6, wherein the second coupler (112) is configured to derive at least one second signal light beam (325) from the second incident light beam (320) originating from the second light source (220) and introduced into the spectral refinement module (100).

8. The spectral refinement module (100) according to any one of claims 2 to 7, comprising a third coupler (113) configured to generate, from at least one signal light beam among the first signal light beam (315) originating from said at least one first coupler (111) and the second signal light beam (325) originating from the second coupler (112), a third signal light beam (335).

9. The spectral refinement module (100) according to claim 8, wherein the third signal light beam (335), totally or partially comprises at least one signal light beam among the first signal light beam (315) of said at least one first light source (210) and the second signal light beam (325) of the second light source (220), the third signal light beam (335) is generated by at least one coupler among said at least one first coupler (111) and the third coupler (113).

10. A refined spectral line device (200) comprising at least one spectral refinement module (100) according to any one of claims 1 to 9 and at least one first light source (210) associated to said at least one spectral refinement module (100).

11. The refined spectral line device (200) according to claim 10, which is configured to emit the first signal light beam (315) or the third signal light beam (335).

12. A spectral refinement method (500) for at least one first light source (210) emitting a first incident light beam (310), the spectral refinement method (500) comprising:

    - a derivation (510) of the first incident light beam (310) originating from said at least one first light source (210) so as to generate a light beam called first pumping light beam (311);
    - a resonation (520) of at least one portion of said light beam called first pumping light beam (311) so as to generate a first resonant light beam;
    - a modulation (530) of at least one portion of the first resonant light beam so as to generate at least one first modulated light beam (313); and
    - a total or partial introduction of said at least one first modulated light beam (313) into said at least one first light source (210).

13. The spectral refinement method (500) according to claim 12, wherein during the modulation step (530), at least one portion of the first resonant light beam (312) is modulated so as to generate a second modulated light beam (323).

14. The spectral refinement method (500) according to claim 13, wherein, during the introduction step, the second modulated light beam (323) is totally or partially introduced into a second light source (220) so as to refine the spectral line of the second light source (220).

15. The spectral refinement method (500) according to any one of claims 12 to 14 using the spectral refinement module (100) according to any one of claims 1 to 9 or the refined spectral line device (200) according to any one of claims 10 and 11.

**Fig. 1**

**Fig. 2**

**Fig. 3**

**Fig. 4**

310

Fig. 5

312

Fig. 6

312    313

Fig. 7

310    320

Fig. 8

**Fig. 9**

312 — 322

**Fig. 10**

312 — 313 — 323

V

**Fig. 11**

315 — 325

V

312

**Fig. 12**

312    313    323

**Fig. 13**

325

**Fig. 14**

315    325

**Fig. 15**

V

**Fig. 16**

**Fig. 17**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2008047329 A2

- US 2011134940 A1

**Littérature non-brevet citée dans la description**

- **THÉVENAZ.** Novel schemes for optical signal génération using laser injection locking with application to Brillouin sensing. *Measuremernt Science and Technology,* 01 Août 2004, vol. 15 (8), 1519-1524

- **CASTRO.** Self-injection locking of DFB laser diode with Brillouin amplification in optical fibre feedback. *Electronics Letters,* 19 Juillet 2007, vol. 43 (15), 802-804